(19) Europäisches Patentamt
European Patent Office
Office européen des brevets

(11) **EP 2 262 000 B1**

(12) **EUROPEAN PATENT SPECIFICATION**

(45) Date of publication and mention
of the grant of the patent:
**30.03.2016 Bulletin 2016/13**

(51) Int Cl.:
***C08K 5/29*** *(2006.01)*    ***H01L 31/048*** *(2006.01)*
***C08J 5/18*** *(2006.01)*

(21) Application number: **09728113.3**

(86) International application number:
**PCT/JP2009/057154**

(22) Date of filing: **01.04.2009**

(87) International publication number:
**WO 2009/123357 (08.10.2009 Gazette 2009/41)**

(54) **FILM FOR SOLAR CELL BACKSIDE PROTECTIVE FILM**

FILM FÜR EINE SOLARZELLEN-RÜCKSEITENSCHUTZFOLIE

FILM POUR FILM PROTECTEUR DE CÔTÉ ARRIÈRE DE CELLULE SOLAIRE

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **02.04.2008 JP 2008096076**
**30.07.2008 JP 2008196196**

(43) Date of publication of application:
**15.12.2010 Bulletin 2010/50**

(73) Proprietor: **Teijin Dupont Films Japan Limited Chiyoda-ku**
**Tokyo 100-0013 (JP)**

(72) Inventors:
• **OKADA, Shinichiro**
**Anpachi-gun**
**Gifu 503-0123 (JP)**
• **MATSUMURA, Naoko**
**Anpachi-gun**
**Gifu 503-0123 (JP)**
• **OYAMATSU, Atsushi**
**Anpachi-gun**
**Gifu 503-0123 (JP)**

(74) Representative: **Cockerton, Bruce Roger**
**Carpmaels & Ransford LLP**
**One Southampton Row**
**London WC1B 5HA (GB)**

(56) References cited:
**EP-A1- 0 738 749      EP-A1- 1 193 050**
**EP-A1- 1 898 470      WO-A1-2007/122936**
**JP-A- 2008 028 294      JP-A- 2008 066 631**
**JP-A- 2008 291 222      US-A1- 2003 068 511**
**US-A1- 2007 054 089**

• **DATABASE WPI Week 200744 Thomson Scientific, London, GB; AN 2007-452122 XP002684671, & JP 2007 099971 A (TEIJIN DUPONT FILMS KK) 19 April 2007 (2007-04-19)**
• **DATABASE WPI Week 200520 Thomson Scientific, London, GB; AN 2005-185839 XP002684672, & JP 2005 029688 A (TORAY IND INC) 3 February 2005 (2005-02-03)**
• **DATABASE WPI Week 200701 Thomson Scientific, London, GB; AN 2007-004379 XP002684673, & JP 2006 306910 A (TEIJIN DUPONT FILMS KK) 9 November 2006 (2006-11-09)**
• **DATABASE WPI Week 200734 Thomson Scientific, London, GB; AN 2007-356846 XP002684674, & JP 2007 070430 A (TORAY IND INC) 22 March 2007 (2007-03-22)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a solar cell back sheet including a film comprising a polyester.

BACKGROUND ART

A photovoltaic power generation system has come into wide use as one of power generating means using clean energy. The solar cell panel for use in the photovoltaic power generation system generally assumes, for example, as described in JP-UM-A-6-38264, a structure in which a plurality of plate-like solar cell elements are interposed between a glass substrate on the light-receptive side and a protective film on the back surface side, and a sealing resin is filled in the internal gap therebetween.

As a sheet-like member to be used as the protective film, a fluorine resin film is known, but is expensive. In recent years, use of a monolayer film or a multilayer film of polyester film has been under study.

DISCLOSURE OF THE INVENTION

PROBLEMS THAT THE INVENTION IS TO SOLVE

A solar cell back sheet is a structural material for protecting a power generating element from the backside, and may be applied with a high voltage. When a voltage is applied thereon, so that partial discharge through the back sheet occurs, the deterioration of the back sheet proceeds. When the partial discharge start voltage can be kept high, the useful life of the solar cell can be elongated. However, with a conventional polyester film for solar cell back sheet, it has been difficult to keep the partial discharge start voltage high over a long period.

It is an object of the present invention to provide a film for solar cell back sheet which can keep the partial discharge start voltage high over a long period, and further is excellent in hydrolysis resistance.

MEANS FOR SOLVING THE PROBLEMS

Namely, the present invention provides a solar cell back sheet comprising a film for solar cell back sheet which includes a biaxially oriented polyester film. The biaxially oriented polyester film includes a polyester composition including 100 parts by weight of a polyester and 0.1 to 10 parts by weight of a carbodiimide compound, being mixed therein.

ADVANTAGE OF THE INVENTION

In accordance with the present invention, it is possible to provide a solar cell back sheet comprising a film for solar cell back sheet which can keep the partial discharge start voltage high over a long period, and further is excellent in hydrolysis resistance.

BEST MODE FOR CARRYING OUT THE INVENTION

Below, the present invention will be described in details.

Film

A film for the solar cell back sheet of the invention is a biaxially oriented polyester film. By being a biaxially oriented polyester film, the film can acquire a necessary and sufficient mechanical strength as the film for solar cell back sheet. When the film is not a biaxially oriented polyester film, but an undrawn film or a uniaxially oriented film, the strength as the film for solar cell back sheet is insufficient.

Polyester composition

The polyester composition forming the film of the solar cell back sheet of the invention is a composition obtained by melt-mixing a polyester and a carbodiimide compound, and is preferably a composition containing a reaction product formed by melt-mixing thereof.

The intrinsic viscosity of the polyester composition (measured using an orthochlorophenol solvent at a temperature of 35 °C) is preferably 0.65 to 1.20 dl/g, and in particular preferably 0.70 to 1.10 dl/g in terms of the value obtained by measuring the film as a sample. An intrinsic viscosity falling within this range can provide a film excellent in mechanical characteristics and hydrolysis resistance.

Then, for the polyester composition, the terminal carboxyl group concentration of the polyester is preferably 3 to 25 eq/T, further preferably 3 to 20 eq/T, and in particular preferably 5 to 15 eq/T in terms of the value obtained by measuring the film as a sample. A terminal carboxyl group concentration falling within this range can provide a film excellent in hydrolysis resistance at a high productivity.

Polyester

As a polyester of the polyester composition forming the film of the solar cell back sheet of the invention, there is used a polyester including an aromatic dicarboxylic acid component and a diol component.

As aromatic dicarboxylic acids, there can be exemplified terephthalic acid, isophthalic acid, 2,6-naphthalenedicarboxylic acid, and 4,4'-diphenyldicarboxylic acid. As diol components, there can be exemplified ethylene glycol, 1,4-butanediol, 1,4-cyclohexanedimethanol, and 1,6-hexanediol.

As polyesters, preferred are polyethylene terephthalate and polyethylene-2,6-naphthalenedicarboxylate. These polyesters may be copolymerized polyesters. In this case, the amount of the copolymerizable components is preferably up to 20 mol% at most. Further, other components may be blended therein so long as the contents thereof are within such a range as not to pose a problem in terms of mechanical characteristics and productivity.

Carbodiimide compound

The polyester composition forming the film of the solar cell back sheet of the invention is a composition obtained by melt-mixing a polyester and a carbodiimide compound, and is preferably a composition containing a reaction product formed by melt-mixing thereof.

The composition can be obtained in the following manner: a carbodiimide compound is mixed in an amount of 0.1 to 10 parts by weight, preferably 0.3 to 7 parts by weight, and further preferably 0.5 to 5 parts by weight per 100 parts by weight of a polyester; and the mixture is melt-kneaded. When the carbodiimide compound is in an amount of less than 0.1 wt%, sufficient hydrolysis resistance cannot be obtained. Further, the partial discharge start voltage cannot be kept high over a long period. When the amount exceeds 10 parts by weight, a favorable hydrolysis resistance cannot be obtained.

In the invention, the carbodiimide compound has a molecular weight of 2000 to 100 000 and is a compound having at least one carbodiimide group in the molecule. As the carbodiimide compounds, for example, monocarbodiimide and polycarbodiimide can be used.

As monocarbodiimides, for example, there can be exemplified N,N'-diphenylcarbodiimide, N,N'-diisopropylphenylcarbodiimide, N,N'-dicyclohexylcarbodiimide, 1,3-diisopropylcarbodiimide, and 1-(3-dimethylaminopropyl)-3-ethylcarbodiimide. Out of these, N,N'-diphenylcarbodiimide and N,N'-diisopropylphenylcarbodiimide are preferable, and N,N'-diphenylcarbodiimide is in particular preferable. When monocarbodiimides are used, they may be used singly, or they may be used in combination of two or more thereof. In any case, N,N'-diphenylcarbodiimide and/or N,N'-diisopropylphenylcarbodiimide preferably accounts for 50 to 100 wt% based on the total amount of monocarbodiimides.

As polycarbodiimide, for example, there can be used a polymer obtained by polymerizing a carbodiimide compound. Specifically, poly(1,3,5-triisopropylphenylene-2,4-carbodiimide) can be exemplified.

From the viewpoints of obtaining a favorable dispersibility during production of a polyester composition, and preventing the carbodiimide compound from volatilizing and vaporizing during film production, it is preferable to use a carbodiimide compound having a number-average molecular weight of 200 to 100000, and it is further preferable to use a carbodiimide compound having a number-average molecular weight of 200 to 50000.

From the viewpoint of dispersing the carbodiimide compound with a particularly favorable dispersibility in the polyester composition, a carbodiimide compound having a number-average molecular weight of 200 to 1000 is preferable. Further, from the viewpoint of minimizing volatilization and vaporization of the carbodiimide compound during film production, and from the viewpoint of keeping the partial discharge start voltage and the hydrolysis resistance of the film high over a longer period, a carbodiimide compound having a number-average molecular weight of 2000 to 100000 is preferable.

The polycarbodiimide for use as the carbodiimide compound having a number-average molecular weight of 2000 to 100000 is also distributed as a commercial product, and is commercially available. The polycarbodiimide can also be synthesized to be used.

When polycarbodiimide is synthesized to be used, it can be synthesized with a commonly well known method. For example, synthesis thereof can be carried out in the following manner. Using an organophosphorus compound or an organometallic compound as a catalyst, various polyisocyanates are subjected to a decarboxylation condensation reaction without solvent or in an inert solvent at a temperature of about 70 °C or more.

In US Pat. No. 2941956, JP-B-47-33279, J. Org. Chem. 28, 2069-2075 (1963), and Chemical Review 1981, Vol. 81, No. 4, p619-621, there are disclosed production methods of polycarbodiimide. Production thereof can also be carried out with the production methods described therein.

Polycarbodiimide can also be obtained by, for example, polymerizing an organic diisocyanate. As organic diisocyanates, for example, aliphatic diisocyanates, alicyclic diisocyanates, and aromatic diisocyanates can be used. These may be used in mixture. Specifically, there can be exemplified hexamethylene diisocyanate, cyclohexane-1,4-diisocyanate, isophorone diisocyanate, dicyclohexylmethane-4,4'-diisocyanate, and methylcyclohexane diisocyanate.

When polycarbodiimide is synthesized by a polymerization reaction, control to an appropriate polymerization degree can be achieved by stopping the polymerization reaction halfway. In this case, isocyanate is at the terminal. In order to stop the polymerization reaction halfway, for example, it is essential only that the reaction system is cooled. In order to achieve control to an appropriate polymerization degree, all of or a part of remaining terminal isocyanates may be blocked using a compound reacting with the terminal isocyanate of polycarbodiimide as a terminal blocking agent. As the terminal blocking agent, for example, monoisocyanate can be used. Specifically, there can be exemplified phenyl isocyanate, tolyl isocyanate, dimethylphenyl isocyanate, cyclohexyl isocyanate, and butyl isocyanate.

Hydrolysis resistance

The film of the solar cell back sheet of the invention has a hydrolysis resistance such that the breaking elongation retention after an elapse of 72 hours under environment of a temperature of 121 °C and a humidity of 100 %RH is 50 % or more.

Originally, the film is demanded to have a durability of 20 years or more in outdoor exposure conditions as a solar cell back sheet. However, the evaluation by the test requiring such a long period is not realistic. For this reason, in the invention, the test is substituted with an acceleration test for measuring the elongation retention in an aging treatment in which 50 hours or 72 hours is allowed to elapse under environment of a temperature of 121 °C and a humidity of 100 %RH.

When the film of the solar cell back sheet uses, as a carbodiimide compound, a relatively low molecular-weight carbodiimide compound having a number-average molecular weight of 200 to 1000, the film preferably has a hydrolysis resistance such that the breaking elongation retention after an elapse of 50 hours under environment of a temperature of 121 °C and a humidity of 100 %RH is 50 % or more.

Further, when the film of the solar cell back sheet of the invention uses, as a carbodiimide compound, a relatively high molecular-weight carbodiimide compound having a number-average molecular weight of 2000 to 100000, the film preferably has a hydrolysis resistance such that the breaking elongation retention after an elapse of 72 hours under environment of a temperature of 121 °C and a humidity of 100 %RH is 50 % or more.

Additives

In the invention, in order to impart the slipperiness to the resulting film and make handling favorable, a lubricant is preferably added to the polyester composition forming the film.

In the invention, to the polyester composition forming the film, there may be added other additives such as pigment, dye, reinforcing agent, filler, heat resistance improver, antioxidant, plasticizer, weather resistance improver, lubricant, mold release agent, nucleating agent, flowability improver, anti-static agent, stabilizer, cross-linking agent, terminal blocking agent, and molecular chain extender so long as the physical properties of the resulting film are not impaired.

Production method

The polyester composition in the invention can also be produced with a method in which a carbodiimide compound is kneaded into a polyester as in the related art. However, production is preferably carried out with a method in which a carbodiimide compound is directly added to the polycondensation reaction system of a polyester. Incidentally, when the kneading method is used, the following procedure is preferable. First, a master chip including a carbodiimide compound added therein to a concentration of 10 to 20 wt% is formed. This is mixed with an additive-free polyester chip, and the mixture is melt-kneaded so as to achieve a desirable carbodiimide compound concentration for use in manufacturing of a film.

For formation of the master chip, a biaxial kneading extruder, particularly, a vent-equipped biaxial kneader is preferably used in order to obtain a sufficient knead-dispersion force.

In the invention, when production is carried out with the method in which a carbodiimide compound is directly added to the polycondensation reaction system of a polyester, deterioration due to thermal decomposition of the polymer during the kneading step can be prevented. Thus, this is preferable. In this case, the timing of addition of the carbodiimide compound is preferably at the stages subsequent to the polycondensation reaction because the heat history applied to the carbodiimide compound can be relieved. Alternatively, the following is preferable because dispersion of the carbodiimide compound can be suppressed: the polycondensation reaction includes a first step of performing deaeration, and making the state closer to vacuum; and a second step of stopping deaeration, and holding the state close to vacuum, and thus not performing deaeration, in this order. In the second step, the carbodiimide compound is added. By adopting this method, it is possible to suppress dispersion of the carbodiimide compound in, for example, the kneading step or the polycondensation reaction step. For this reason, suppression of evaporation and vaporization does not require use of a carbodiimide compound having an excessively large molecular weight. This can suppress the adverse effects caused by decomposition of the carbodiimide compound itself due to use of a carbodiimide compound having an excessively large molecular weight, and reduction of the dispersibility of the carbodiimide compound.

Incidentally, polyester itself can be produced using a conventionally known method. Production can be carried out with a melt polymerization method such as an ester interchange method or a direct esterification method, or a solution polymerization method. As the ester interchange catalysts, there can be used, for example, compounds of manganese, cobalt, zinc, titanium, and calcium. As the esterification catalysts, there can be used, for example, compounds of manganese, cobalt, zinc, titanium, and calcium. As the polycondensation catalysts, there can be used, for example, compounds of germanium, antimony, tin, and titanium.

The film of the solar cell back sheet of the invention can be obtained in the following manner. A polyester composition to which a carbodiimide compound has been previously added is melt-extruded in a film form. Alternatively, a polyester composition to which a carbodiimide compound has been added to a high concentration is used as a master chip, and this and an additive-free polyester chip are mixed, and melt-kneaded. The resulting melt-kneaded mixture is melt-extruded into a film form. Further alternatively, at the inlet feed portion of the extruder for melt-kneading, a carbodiimide compound is directly added and fed in a powder or liquid state to a polyester chip, followed by melt-kneading. The resulting melt-extruded product is cooled and solidified in a casting drum, resulting in an undrawn film. Then, the undrawn film is drawn at Tg to (Tg+60) °C in the longitudinal direction one time or two or more times to a total draw ratio of 3 times to 6 times. Then, the film is drawn at Tg to (Tg+60) °C in the width direction to a draw ratio of 3 to 5 times. If required, the film is further subjected to a heat treatment at 180 °C to 255 °C for 1 to 60 seconds.

Drawing in the longitudinal direction and in the width direction may be carried out with sequential biaxial drawing, or may also be carried out with simultaneous biaxial drawing. In order to enhance the dimensional stability upon heating, it is possible to use the method in which shrinkage in the longitudinal direction is accomplished in a heat treatment step shown in JP-A-57-57628, or the method in which the film is subjected to a relaxation heat treatment in a suspended state shown in JP-A-1-275031.

The thickness of the biaxially oriented polyester film obtained by biaxial drawing is preferably 25 to 300 μm, and further preferably 38 to 250 μm.

The film for solar cell back sheet of the invention may be provided with an easily adhesive coating film. The easily adhesive coating film can be provided in the following manner: a drawable polyester film is coated with an aqueous liquid containing components for forming a coating film of an acrylic resin or a polyester resin containing cross-linkable components, followed by drying, drawing, and a heat treatment. When the coating film is provided, the thickness of the coating film is preferably 0.01 to 1 μm

Solar cell back sheet

The film of the solar cell back sheet of the invention is preferably formed into a laminate including a water vapor barrier layer stacked therein to serve as a solar cell back sheet. For the laminate, the transmittance of water vapor measured according to JIS Z0208-73 is preferably 5 g/ (m$^2$·24h) or less.

As the water vapor barrier layer, a film or foil having a water vapor barrier property may be used, or a deposited film or a coating film of a metal oxide may be used.

As the films having a water vapor barrier property, there can be used, for example, a polyvinylidene chloride film, a polyvinylidene chloride coated film, a polyvinylidene fluoride coated film, a film provided with a thin deposited film of an inorganic oxide, and a film provided with a thin deposited film of a metal. As the films provided with a thin deposited film of an inorganic oxide, there can be exemplified a silicon oxide-deposited film and an aluminum oxide-deposited film. As the film provided with a thin metal-deposited film, an aluminum-deposited film can be exemplified.

As the foils having a water vapor barrier property, there can be exemplified aluminum foil and copper foil.

When a film or foil having a water vapor barrier property is used as the water vapor barrier layer, the film or foil having a water vapor barrier property is preferably stacked on at least one side of the film for solar cell back sheet via an adhesive.

Further, as the water vapor barrier layer, a thin deposited film or a coating film of an inorganic oxide, or a thin deposited film of a metal may be used. As the thin deposited film or coating film of an inorganic oxide, for example, silicon oxide or aluminum oxide can be used. As the thin deposited film of a metal, for example, aluminum can be used.

A solar cell back sheet obtained by stacking a thin deposited film layer of an inorganic oxide on the film for solar cell back sheet of the invention is excellent in water vapor barrier property, and hence is preferable.

The films of the solar cell back sheet of the invention may be used alone, or may be used in lamination of two or more thereof. Further, for the purpose of enhancing the insulating characteristics, the film may be bonded with another transparent polyester film. Still further, for the purpose of enhancing the durability, the film may be bonded with a film including a high weather resistant resin such as polyvinyl fluoride.

The film of the solar cell back sheet of the invention is preferably formed into the following configuration: as described above, a water vapor barrier layer is stacked thereon, further thereon, a white film is stacked, and thereon, an EVA (ethylene vinyl acetate) layer for sealing a solar cell element is provided; namely, into a configuration of film for solar cell back sheet of the invention/ water vapor barrier layer/white film/EVA layer, to serve as a solar cell back sheet.

Alternatively, the film of the solar cell back sheet of the invention is preferably formed into the following configuration: as described above, a water vapor barrier layer is stacked thereon, further, a white film is stacked on the opposite side from the water vapor barrier layer, and thereon, an EVA (ethylene vinyl acetate) layer for sealing a solar cell element is provided; namely, into a configuration of water vapor barrier layer/film for solar cell back sheet of the invention/white film/EVA layer, to serve as a solar cell back sheet.

Examples

Below, the invention will be described in details by way of examples. Incidentally, the measurements and evaluations were carried out in the following manner.

(1) Intrinsic viscosity

The viscosity of a solution of a film sample with an orthochlorophenol solvent was measured at 35 °C, and determined.

(2) Number-average molecular weight

Using tetrahydrofuran as a developing solvent, measurement was carried out with gel permeation chromatography. As a measuring device, HLC8120 (manufactured by Tosoh Corporation Ltd.) was used. As a column, GMHHR-H+GMHHR-H+G2000HHR (manufactured by Tosoh Corporation Ltd.) was used.

(3) Terminal carboxyl group concentration

A film sample was dissolved in benzyl alcohol under a nitrogen atmosphere, and the measurement was carried out with a titration method.

(4) Partial discharge start voltage

On one side of a biaxially drawn polyethylene terephthalate film (manufactured by TEIJIN DUPONT FILMS JAPAN LIMITED, trade name: Teijin Tetoron NS) with a thickness of 12 $\mu$m, a thin deposited film layer of silicon oxide with a thickness of 80 nm was provided. The resulting film was prepared as a water vapor barrier film. Further, a biaxially drawn polyethylene terephthalate film (manufactured by TEIJIN DUPONT FILMS JAPAN LIMITED, trade name: Teij in Tetoron U2) with a thickness of 50 $\mu$m was prepared as a white film. The resulting films were combined with the film for solar cell back sheet of the invention. The films were bonded together by means of a dry laminator using a polyurethane adhesive (basis TAKELAC A515/curing agent TAKENATE A50=10/1 solution) manufactured by Takeda Pharmaceutical Company Limited so as to be in the order of white film/water vapor barrier film/film for solar cell back sheet of the invention, thereby to manufacture a solar cell back sheet.

Using the solar cell back sheet, the partial discharge start voltages (Umax) before and after a wet heat treatment (allowing a prescribed time to elapse under environment of a temperature of 121 °C and a humidity 100 %RH) were measured using a partial discharge tester (model KPD2050) manufactured by KIKUSUI ELECTRONICS CORP. Ltd., according to the partial discharge test of IEC60664-1. Incidentally, the measurements were carried out for 10 samples, and the mean value thereof was calculated.

Incidentally, it is essentially desirable to evaluate the partial discharge start voltage after an elapse of 20 years or so with the film as the solar cell back sheet in outdoor exposure conditions. However, it is difficult to spend such a long time to perform the outdoor exposure test. For this reason, in place of this evaluation, an acceleration test in which a prescribed time is allowed to elapse under environment of a temperature of 121 °C and a humidity of 100 %RH is performed. Thus, the partial discharge start voltage is evaluated.

In Reference Examples 1 to 4 and Comparative Example 1, the prescribed time of the acceleration test was set at 50 hours. In Examples 1 to 6 and Comparative Examples 2 and 3, the prescribed time of the acceleration test was set at 72 hours. Thus, evaluation was carried out.

(5) Hydrolysis resistance

A film was cut in a length of 100 mm in the longitudinal direction and in a width of 10 mm in the transverse direction, resulting in a specimen in a strip form. The specimen was allowed to stand in an environment tester set to a temperature of 121 °C and a humidity of 100 %RH for a prescribed time. Then, the specimen was taken out. The breaking elongation in the longitudinal direction was measured 5 times, and the mean value thereof was determined. The value obtained by dividing the mean value by the measurement value of the breaking elongation before standing was taken as the breaking elongation retention (%).

```
Breaking elongation retention (%)

= (breaking elongation after an elapse of prescribed

time)/(initial breaking elongation)×100
```

Incidentally, it is essentially desirable to evaluate the hydrolysis resistance after an elapse of 20 years or so with the film as the solar cell back sheet in outdoor exposure conditions. However, it is difficult to spend such a long time to perform the outdoor exposure test. For this reason, in place of this evaluation, an acceleration test in which a prescribed time is allowed to elapse under environment of a temperature of 121 °C and a humidity of 100 %RH is performed. Thus, the breaking elongation retention is evaluated.

In Reference Examples 1 to 4 and Comparative Example 1, the prescribed time of the acceleration test was set at 50 hours. In Examples 1 to 6 and Comparative Examples 2 and 3, the prescribed time of the acceleration test was set at 72 hours. Thus, evaluation was carried out.

Reference Example 1

85 Parts by weight of dimethyl terephthalate and 60 parts by weight of ethylene ethylene glycol were charged in a reactor using 0.08 part by weight of calcium acetate as a catalyst. The temperature was increased up to 240 °C under a nitrogen atmosphere. Thus, an ester interchange reaction was effected. After the distillation amount of methanol had reached 90 % or more based on the theoretical amount, there was added thereto an ethylene glycol solution adjusted to contain trimethyl phosphate in an amount of 10 wt% so as to be in an amount of 0.18 wt% in terms of phosphorus compound based on the amount of the polymer, and aggregated silicon oxide particles with an average particle size of 1. 5 $\mu$m in an amount of 350 ppm based on the amount of the polymer. Then, as a polymerization catalyst, 0. 03 part by weight of diantimony trioxide was added thereto. Then, temperature rising and pressure reduction were gradually performed according to the ordinary method. Finally, at the time when a prescribed melt viscosity was obtained, as a carbodiimide compound, N,N'-dicyclohexylcarbodiimide (manufactured by Matsumoto Yushi Seiyaku Co. , Ltd, molecular weight=206) was added in the amount shown in Table 1. Then, the inside of the reactor was kept at 3.0 kPa for 10 minutes, and the reaction was terminated, resulting in a polyethylene terephthalate composition with an intrinsic viscosity of 0.87 and a melting point of 256 °C. This was melt-extruded on a rotary cooling drum kept at 20 °C using an extruder heated to 285 °C, resulting in an undrawn film. Then, the resulting film was drawn to 3.8 times at 100 °C in the longitudinal direction, and then was drawn to 4.2 times at 110 °C in the width direction. Thus, the film was heat set while being shrunk by 3 % along the width direction at 225 °C, resulting in a film for solar cell back sheet with a thickness of 50 $\mu$m. The hydrolysis resistance (breaking elongation retention) of the film was evaluated. Further, for the film, the intrinsic viscosity and the terminal carboxyl group concentration of the polyester composition forming this were measured.

Then, using the film, a solar cell back sheet was manufactured. First, as a water vapor barrier film, there was prepared a water vapor barrier film manufactured by providing a thin deposited film layer of silicon oxide with a thickness of 80 nm on one side of a biaxially drawn polyethylene terephthalate film (manufactured by TEIJIN DUPONT FILMS JAPAN LIMITED, trade name: Teij in Tetoron NS) with a thickness of 12 $\mu$m. Further, as a white film, there was prepared a biaxially drawn polyethylene terephthalate film (manufactured by TEIJIN DUPONT FILMS JAPAN LIMITED, trade name : Teij in Tetoron U2) with a thickness of 50 $\mu$m. These were bonded together by mans of a dry laminator so as to be in the order of white film/water vapor barrier film/film for solar cell back sheet of the invention, thereby to manufacture a solar cell back sheet. For the solar cell back sheet, the partial discharge start voltages before and after a wet heat treatment (allowing 50 hours to elapse under environment of a temperature of 121 °C and a humidity 100 %RH) were measured.

The measurement results are shown in Table 1.

Reference Example 2

A film for solar cell back sheet and a solar cell back sheet were manufactured in the same manner as in Reference Example 1, except that the amount of the carbodiimide compound to be added was changed as shown in Table 1. The measurement results are shown in Table 1.

Reference Example 3

Using a biaxial knead-extruder NEXT-60 manufactured by Kobe Steel Ltd., polyethylene terephthalate FK-OM manufactured by Teij in Fibers Limited, and, as a carbodiimide compound, N,N'-dicyclohexylcarbodiimide (manufactured by Matsumoto Yushi Seiyaku Co., Ltd, molecular weight=206) were fed so as to achieve a weight ratio of 100:5. The mixture was melt-kneaded, and was extruded at a speed of 120 kg/h, resulting in a polyethylene terephthalate composition with an intrinsic viscosity of 0.86. A film for solar cell back sheet and a solar cell back sheet were manufactured using this composition in the same manner as in Reference Example 1. The measurement results are shown in Table 1.

Comparative Example 1

A film for solar cell back sheet and a solar cell back sheet were manufactured in the same manner as in Reference Example 1, except that a carbodiimide compound was not added to a polyester. The measurement results are shown in Table 1.

Reference Example 4

The polyethylene terephthalate composition obtained in Reference Example 1 was further subjected to solid phase polymerization under environment of a temperature of 230 °C and a degree of vacuum of 0.5 mmHg for 24 hours, resulting in a polyethylene terephthalate composition with an intrinsic viscosity of 1.12. A film for solar cell back sheet and a solar cell back sheet were manufactured in the same manner as in Reference Example 1, except that this composition was used as the polyester composition of raw material for the film.

The measurement results are shown in Table 1.

Table 1

| | | Raw material composition | | Film characteristics | | | | |
| --- | --- | --- | --- | --- | --- | --- | --- | --- |
| | | | | Composition characteristics | | Partial discharge start voltage | | Hydrolysis resistance |
| | | Polyester | Carbodiimide compound | Intrinsic viscosity | Terminal carboxyl group concentration | Before acceleration test (before wet heat treatment) | After acceleration test (after wet heat treatment) | Breaking elongation retention |
| | | Parts by weight | Parts by weight | dl/g | eq/T | V | V | % |
| | R. Ex. 1 | 100 | 3 | 0.72 | 9 | 1103 | 1069 | 82 |
| | R. EX. 2 | 100 | 1 | 0.69 | 14 | 1098 | 1061 | 76 |
| | R. Ex. 3 | 100 | 5 | 0.73 | 9 | 1085 | 1050 | 89 |
| | R. Ex. 4 | 100 | 3 | 1.01 | 5 | 1112 | 1076 | 92 |

(continued)

| | Raw material composition | | Film characteristics | | | | |
|---|---|---|---|---|---|---|---|
| | | | Composition characteristics | | Partial discharge start voltage | | Hydrolysis resistance |
| | Polyester | Carbodiimide compound | Intrinsic viscosity | Terminal carboxyl group concentration | Before acceleration test (before wet heat treatment) | After acceleration test (after wet heat treatment) | Breaking elongation retention |
| | Parts by weight | Parts by weight | dl/g | eq/T | V | V | % |
| Comp. Ex. 1 | 100 | 0 | 0.65 | 37 | 1109 | 323 | 43 |

R. Ex. (Reference Example)

Example 1

85 Parts by weight of dimethyl terephthalate and 60 parts by weight of ethylene ethylene glycol were charged in a reactor using 0.08 part by weight of calcium acetate as a catalyst. The temperature was increased up to 240 °C under a nitrogen atmosphere. Thus, an ester interchange reaction was effected. After the distillation amount of methanol had reached 90 % or more based on the theoretical amount, there was added thereto an ethylene glycol solution adjusted to contain trimethyl phosphate in an amount of 10 wt% so as to be in an amount of 0.18 wt% in terms of phosphorus compound based on the amount of the polymer, and aggregated silicon oxide particles with an average particle size of 1.5 $\mu$m in an amount of 350 ppm based on the amount of the polymer. Then, as a polymerization catalyst, 0.03 part by weight of diantimony trioxide was added thereto. Then, temperature rising and pressure reduction were gradually performed according to the ordinary method. Finally, at the time when a prescribed melt viscosity was obtained, as a carbodiimide compound, Carbodilight LA-1 (manufactured by Nisshinbo Industries Inc, molecular weight=6000, carbodiimide equivalent=247 g/mol) was added in the amount shown in Table 1. Then, the inside of the reactor was kept at 3.0 kPa for 10 minutes, and the reaction was terminated, resulting in a polyethylene terephthalate composition with an intrinsic viscosity of 0.87 and a melting point of 255 °C. This was melt-extruded on a rotary cooling drum kept at 20 °C using an extruder heated to 285 °C, resulting in an undrawn film. Then, the resulting film was drawn to 3. 8 times at 100 °C in the longitudinal direction, and then was drawn to 4.4 times at 110 °C in the width direction. Thus, the film was heat set while being shrunk by 3 % along the width direction at 225 °C, resulting in a film for solar cell back sheet with a thickness of 50 $\mu$m.

Using the resulting film for solar cell back sheet, a solar cell back sheet was manufactured in the same manner as in Reference Example 1. For the solar cell back sheet, the partial discharge start voltages before and after a wet heat treatment (allowing 72 hours to elapse under environment of a temperature of 121 °C and a humidity 100 %RH) were measured.

The measurement results are shown in Table 2.

Example 2

A film for solar cell back sheet and a solar cell back sheet were manufactured in the same manner as in Example 1, except that the amount of the carbodiimide compound to be added was changed as shown in Table 2. The measurement results are shown in Table 2.

Example 3

A film for solar cell back sheet and a solar cell back sheet were manufactured in the same manner as in Example 1, except that the compound used as the carbodiimide compound was changed to Carbodilight HMV-8CV (manufactured by Nisshinbo Industries Inc., molecular weight=3000, carbodiimide equivalent=278 g/mol). The measurement results are shown in Table 2.

Example 4

A film for solar cell back sheet and a solar cell back sheet were manufactured in the same manner as in Example 1, except that the compound used as the carbodiimide compound was changed to Stabaxol P200 (manufactured by Rhein Chemie Japan, Ltd., molecular weight=40000, carbodiimide equivalent=330 g/mol). The measurement results are shown in Table 2.

Comparative Example 2

A film for solar cell back sheet and a solar cell back sheet were manufactured in the same manner as in Example 1, except that a carbodiimide compound was not added. The measurement results are shown in Table 2.

Comparative Example 3

A film for solar cell back sheet and a solar cell back sheet were manufactured in the same manner as in Example 1, except that as a carbodiimide compound, diisopropylcarbodiimide (manufactured by Toyo Chemical Industry Co., Ltd.) was used. The measurement results are shown in Table 2. The low molecular weight resulted in volatilization and vaporization of the most part thereof during polymerization and during melt-extrusion. As a result, the addition effect was low.

Example 5

Using a biaxial knead-extruder NEXT-60 manufactured by Kobe Steel Ltd., polyethylene terephthalate FK-OM manufactured by Teij in Fibers Limited, and, as a carbodiimide compound, Carbodilight LA-1 were fed in amounts shown in Table 2. The mixture was melt-kneaded, and was extruded at a speed of 120 kg/h, resulting in a polyethylene terephthalate composition with an intrinsic viscosity of 0.86. A film for solar cell back sheet and a solar cell back sheet were manufactured in the same manner as in Example 1, except that this composition was used as a raw material for the film. The measurement results are shown in Table 2.

Example 6

The polyethylene terephthalate composition obtained in Example 1 was further subjected to solid phase polymerization under environment of a temperature of 230 °C and a degree of vacuum of 0.5 mmHg for 24 hours, resulting in a polyethylene terephthalate composition with an intrinsic viscosity of 1.02. A film for solar cell back sheet and a solar cell back sheet were manufactured in the same manner as in Example 1, except that the polyethylene terephthalate composition was used. The measurement results are shown in Table 2.

Table 2

| | Raw material composition | | Film characteristics | | | | |
| | | | Composition characteristics | | Partial discharge start voltage | | Hydrolysis resistance |
| | Polyester | Carbodiimide compound | Intrinsic viscosity | Terminal carboxyl group concentration | Before acceleration test (before wet heat treatment) | After acceleration test (after wet heat treatment) | Breaking elongation retention |
| | Parts by weight | Parts by weight | dl/g | eq/T | V | V | % |
| Ex. 1 | 100 | 3 | 0.73 | 9 | 1109 | 1077 | 84 |
| EX. 2 | 100 | 1 | 0.70 | 15 | 1097 | 1060 | 78 |
| Ex. 3 | 100 | 3 | 0.74 | 8 | 1116 | 1079 | 81 |
| Ex. 4 | 100 | 3 | 0.75 | 7 | 1120 | 1075 | 82 |
| Ex. 5 | 100 | 5 | 0.76 | 8 | 1128 | 1081 | 88 |

(continued)

| | Raw material composition | | Film characteristics | | | | |
|---|---|---|---|---|---|---|---|
| | Polyester | Carbodiimide compound | Composition characteristics | | Partial discharge start voltage | | Hydrolysis resistance |
| | | | Intrinsic viscosity | Terminal carboxyl group concentration | Before acceleration test (before wet heat treatment) | After acceleration test (after wet heat treatment) | Breaking elongation retention |
| | Parts by weight | Parts by weight | dl/g | eq/T | V | V | % |
| Ex. 6 | 100 | 3 | 1.02 | 3 | 1145 | 1096 | 94 |
| Comp. Ex. 2 | 100 | 0 | 0.64 | 36 | 1113 | 332 | 41 |
| Comp. Ex. 3 | 100 | 1 | 0.63 | 32 | 1103 | 504 | 55 |

INDUSTRIAL APPLICABILITY

The film for solar cell back sheet of the present invention can be preferably used as a solar cell back sheet.

**Claims**

1.    A solar cell back sheet comprising a film comprising a biaxially oriented polyester film, the biaxially oriented polyester film comprising a polyester composition containing 100 parts by weight of a polyester and 0.1 to 10 parts by weight of a carbodiimide compound being mixed therein, wherein the carbodiimide compound has a number-average molecular weight of 2000 to 100000, measured by GPC as disclosed in the description and the film has breaking elongation retention after an elapse of 72 hours under environment of a temperature of 121 °C and a humidity of 100 %RH is 50 % or more.

**Patentansprüche**

1.    Solarzellen-Rückseitenabdeckung, umfassend eine Folie, die eine biaxial orientierte Polyesterfolie umfasst, wobei die biaxial orientierte Polyesterfolie eine Polyesterzusammensetzung umfasst, die 100 Gewichtsteile eines Polyesters und 0,1 bis 10 Gewichtsteile einer Carbodiimidverbindung darin eingemischt enthält, wobei die Carbodiimidverbindung ein mittels GPC gemäß der Beschreibung gemessenes zahlenmittleres Molekulargewicht von 2000 bis 100.000 aufweist und die Folie eine Bruchdehnungsretention nach Verstreichen von 72 Stunden in einer Umgebung mit einer Temperatur von 121°C und einer Feuchte von 100% RF von 50% oder mehr aufweist.

**Revendications**

1.    Support de cellules photovoltaïques comprenant un film comprenant un film de polyester à orientation biaxiale comprenant une composition de polyester contenant 100 parties en poids d'un polyester et 0,1 à 10 parties en poids d'un composé cyanamide mélangées dans celle-ci, le composé cyanamide présentant une moyenne en nombre du poids moléculaire de 2000 à 100000, mesurée par chromatographie par perméation sur gel comme divulgué dans la description et le film présentant une conservation de l'allongement à la rupture après une période de 72 heures dans un environnement à une température de 121 °C et une humidité de 100 % en humidité relative étant de 50 % ou plus.

## REFERENCES CITED IN THE DESCRIPTION

**Patent documents cited in the description**

- US 2941956 A
- JP 47033279 B
- JP 57057628 A
- JP 1275031 A

**Non-patent literature cited in the description**

- *J. Org. Chem.,* 1963, vol. 28, 2069-2075
- *Chemical Review,* 1981, vol. 81 (4), 619-621